(19)

Europäisches Patentamt

European Patent Office

Office européen des brevets

(11)     **EP 4 697 037 A1**

(12)                                   **EUROPEAN PATENT APPLICATION**

(43) Date of publication:
**18.02.2026   Bulletin 2026/08**

(21) Application number: **25194708.1**

(22) Date of filing: **07.08.2025**

(51) International Patent Classification (IPC):
**G01R 31/367** (2019.01)      **G01R 31/382** (2019.01)

(52) Cooperative Patent Classification (CPC):
**G01R 31/367; G01R 31/382;** G01R 31/3835;
G01R 31/389

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **12.08.2024   CN 202411102399**

(71) Applicant: **Solax Power Network
Technology (Zhejiang) Co., Ltd.
Hangzhou, Zhejiang 311500 (CN)**

(72) Inventor: **YAO, Zhenfei
Hangzhou, 311500 (CN)**

(74) Representative: **Murgitroyd & Company
165-169 Scotland Street
Glasgow G5 8PL (GB)**

(54)     **BATTERY MODEL PARAMETER IDENTIFICATION METHOD, BATTERY STATE OF CHARGE
ESTIMATION METHOD, BATTERY OPEN-CIRCUIT VOLTAGE ESTIMATION METHOD,
ENERGY STORAGE DEVICE, READABLE MEDIUM AND COMPUTER PROGRAM PRODUCT**

(57)     A method includes: fitting, based on a battery parameter of a pulse segment, a target model parameter using a fitting algorithm, to obtain an initial fitted value of the target model parameter; inputting the initial fitted value into a fitting optimization algorithm, and performing, based on battery parameters of a rest segment and the pulse segment, fitting optimization on the target model parameter using the fitting optimization algorithm, to obtain an optimized value of an optimized target model parameter; calculating, based on the battery parameter of the rest segment and the optimized value, a first difference between a predicted value and an actual value of an open-circuit voltage; and using the optimized value as an identified target model parameter in a case that the first difference does not exceed a preset difference. The method aims to address an issue of poor parameter identification precision in related technologies.

FIG. 1

EP 4 697 037 A1

# EP 4 697 037 A1

**Description**

## TECHNICAL FIELD

The present invention relates to the field of battery control technologies, and in particular, to a battery model parameter identification method, a battery state of charge estimation method, a battery open-circuit voltage estimation method, an energy storage device, a readable medium and a computer program product.

## BACKGROUND

Lithium-ion battery models are mainly divided into an equivalent circuit model and an electrochemical model. The electrochemical model may accurately reflect electrochemical reactions within a lithium-ion battery with relatively high precision. However, it is relatively difficult to calibrate chemical parameters of various raw materials of the lithium-ion battery. At present, a second-order equivalent circuit model of a lithium-ion battery is widely used in estimation of State of Charge (SOC), State of Power (SOP), and State of Health (SOH) due to its relatively low computational load, relatively high precision, and ease of parameter identification, and one of its core aspects lies in parameter identification for the second-order equivalent circuit of the lithium-ion battery.

Currently, commonly used parameter identification are divided into offline parameter identification and online parameter identification, and commonly used parameter identification methods include a least squares method, particle swarm optimization, a genetic algorithm, or the like. However, during a parameter identification process, these parameter identification methods use a segment of data for fitting, ultimately resulting in poor precision and low accuracy of identified parameters.

Regarding a parameter identification method for a battery equivalent circuit model in related technologies, there is an issue of poor parameter identification precision, and no effective solution has been proposed yet.

## SUMMARY

Embodiments of the present invention provide a battery model parameter identification method, a battery state of charge estimation method, a battery open-circuit voltage estimation method, an energy storage device, a readable medium and a computer program product, at least solving an issue of poor parameter identification precision in a parameter identification method for a battery equivalent circuit model in related technologies.

The embodiments of the present invention provide a battery model parameter identification method, including: fitting, based on an equivalent circuit model of a target battery and a battery parameter of a pulse segment in an open-circuit voltage-time curve, a target model parameter in the equivalent circuit model using a fitting algorithm, to obtain an initial fitted value of the target model parameter, where the pulse segment is a time segment between adjacent parameter identification cycles in the open-circuit voltage-time curve, during which an open-circuit voltage decreases after an end of a previous parameter identification cycle and increases after a start of a next parameter identification cycle; inputting the initial fitted value into a fitting optimization algorithm, and performing, based on a battery parameter of a rest segment in the open-circuit voltage-time curve and the battery parameter of the pulse segment, fitting optimization on the target model parameter using the fitting optimization algorithm, to obtain an optimized value of an optimized target model parameter; calculating, based on the battery parameter of the rest segment and the optimized value, a first difference between a predicted value and an actual value of the open-circuit voltage; and using the optimized value as an identified target model parameter in a case that the first difference does not exceed a preset difference.

As an optional embodiment, the method further includes: calculating, based on the battery parameter of the pulse segment and the optimized value, a second difference between a predicted value and an actual value of a terminal voltage of the pulse segment in a case that the first difference exceeds the preset difference; scaling, based on the second difference, the optimized value, to obtain a correction value; using the correction value as a current optimized value, and recalculating, based on the battery parameter of the rest segment and the current optimized value, a first difference between a predicted value and an actual value of the open-circuit voltage; and using the current optimized value as an identified target model parameter in a case that the first difference after recalculation does not exceed the preset difference.

As an optional embodiment, the calculating, based on the battery parameter of the rest segment and the optimized value, the first difference between the predicted value and the actual value of the open-circuit voltage includes: calculating, based on optimized values of polarization resistance and a time constant in the target model parameter and the battery parameter of the rest segment, the predicted value of the open-circuit voltage; and calculating the first difference based on the predicted value of the open-circuit voltage and the actual value, in the battery parameter of the rest segment, of the open-circuit voltage.

As an optional embodiment, the fitting, based on the equivalent circuit model of the target battery and the battery parameter of the pulse segment in the open-circuit voltage-time curve, the target model parameter in the equivalent circuit model using the fitting algorithm, to obtain the initial fitted value of the target model parameter includes: calculating, based on a terminal voltage of the pulse segment and an initial voltage of the rest segment, ohmic resistance; determining, based on the ohmic resistance and the battery parameter of the pulse segment, an initial value and upper and lower limits of polarization resistance; and using an initial value and upper and lower limits of a time constant that are preset, the initial value and the upper and lower limits of the polarization resistance, and a value of the ohmic resistance as the initial fitted value of the target model parameter, where the target model parameter includes ohmic resistance, polarization resistance, and a time constant.

As an optional embodiment, the method further includes: testing the target battery to obtain test data during a testing process, where the test data includes testing the target battery to obtain test data during a testing process; and preprocessing the test data to obtain the open-circuit voltage-time curve and a battery parameter of each time segment, where the battery parameter of each time segment includes at least one of the following: a current, a voltage, capacity, time, a temperature, state of charge of a battery.

As an optional embodiment, the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter includes: using an initial fitted value of a time constant as an initial value, and inputting the initial value into a fitting optimization function; calculating, based on the battery parameter of the pulse segment and the battery parameter of the rest segment, the open-circuit voltage of the target battery using the fitting optimization function; determining, based on the open-circuit voltage of the target battery and an actual open-circuit voltage of the target battery, a voltage error value; using a value of the time constant as an optimized value of the time constant in a case that the voltage error value is less than a preset maximum allowable error; and calculating, based on the optimized value of the time constant, an optimized value of polarization resistance.

As an optional embodiment, the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter further includes: in a case that the voltage error value is not less than the preset maximum allowable error, performing statistical processing and filtering on the voltage error value, and determining a quantity of consecutive times for which the voltage error value is not less than the preset maximum allowable error; and in a case that the quantity of consecutive times reaches a quantity of preset times, adjusting an initial value and an upper limit of a time constant, and recalculating an open-circuit voltage of the target battery and a voltage error value until the voltage error value is less than the preset maximum allowable error.

As an optional embodiment, the equivalent circuit model is a second-order resistor-capacitor equivalent circuit model.

The embodiments of the present invention further provides a battery state of charge estimation method, including: determining ohmic resistance, polarization resistance, and a time constant of a target battery using any of the aforementioned battery model parameter identification methods; and estimating, based on the ohmic resistance, the polarization resistance and the time constant, state of charge of the target battery using a state equation and a kalman state equation of a second-order equivalent circuit model of the target battery.

The embodiments of the present invention further provide a battery open-circuit voltage estimation method, including: determining an identified target model parameter using any of the aforementioned battery model parameter identification methods; and estimating, based on the identified target model parameter, an open-circuit voltage.

The embodiments of the present invention further provide an energy storage device, including: a processor, and a memory storing a program, where the program includes an instruction that, when executed by a processor, causes the processor to execute any of the aforementioned methods.

The embodiments of the present invention further provide a non-transitory machine-readable medium storing a computer instruction, where the computer instruction is configured to cause a computer to execute any of the aforementioned methods.

The embodiments of the present invention further provide a computer program product, including a computer program/instruction, where the computer program/instruction, when executed by a processor, implements any of the aforementioned methods.

In the battery model parameter identification method provided by the embodiments of the present invention, the fitting algorithm is firstly applied for fitting the target model parameter using the battery parameter of the pulse segment to obtain the initial fitted value of the target model parameter, and then the target model parameter is optimized based on the battery parameter of the rest segment using the fitting optimization algorithm to obtain the optimized value, so that the target model parameter that satisfies voltage errors of both the pulse segment and the rest segment is obtained, thereby improving accuracy and precision in target model parameter identification, and reducing an error in target model parameter identification. As a result, an issue of poor parameter identification precision in a parameter identification method for a battery equivalent circuit model in related technologies is solved.

## BRIEF DESCRIPTION OF THE DRAWINGS

To more clearly illustrate technical solutions in embodiments of the present invention or related technologies, drawings that are required to be used in description of the embodiments or related technologies will be briefly introduced below. Apparently, the drawings in the following description only illustrate some embodiments of the present invention. As for those with ordinary skill in the art, other embodiments may also be obtained according to these drawings without creative work.

FIG. 1 is a flowchart of a battery model parameter identification method provided by an embodiment of the present invention.
FIG. 2 is a flowchart of a battery state of charge estimation method provided by an embodiment of the present invention.
FIG. 3 is a schematic diagram of a pulse segment and a rest segment in an open-circuit voltage-time curve provided by an implementation of the present invention.
FIG. 4 is a schematic diagram of an estimated curve and an actual curve of battery state of charge versus time provided by an implementation of the present invention.
FIG. 5 is a schematic diagram of an estimated curve and an actual curve of an open-circuit voltage versus time provided by an implementation of the present invention.
FIG. 6 is a schematic structural diagram of an energy storage device provided by the present invention.

## DETAILED DESCRIPTION OF THE EMBODIMENTS

Embodiments of the present invention will be described in more detail below with reference to drawings. Although certain embodiments of the present invention are shown in the drawings, it should be understood that the present invention may be implemented in various forms and should not be interpreted as being limited to the embodiments described herein. On the contrary, these embodiments are provided to make an understanding of the present invention more thorough and complete. It should be understood that the drawings and the embodiments of the present invention are only for illustrative purposes and are not intended to limit the scope of protection of the present invention.

Fitting algorithms in related technologies mostly focus on using either a pulse segment or a rest segment in an OCV (Open-Circuit Voltage) curve as fitting data. Since time constants of lithium-ion batteries are different under current flow and no-current conditions, the time constant obtained by simply using the pulse segment for fitting is very small, resulting in a rapid response to the current. However, this leads to a significant voltage prediction error when the current ceases, thereby increasing an overall estimation error. Conversely, the time constant obtained by simply using the rest segment for fitting is significant, resulting in a small voltage error under a rest condition but a relatively slow response to the current. Consequently, this leads to a large voltage prediction error under current flow. This means that in the related technologies, regardless of whether a battery parameter of the pulse segment or a battery parameter of the rest segment is employed for fitting with a fitting algorithm, there will be issues of poor accuracy and poor precision in parameter identification.

To solve the above technical issues, the embodiments of the present invention provide a battery model parameter identification method.

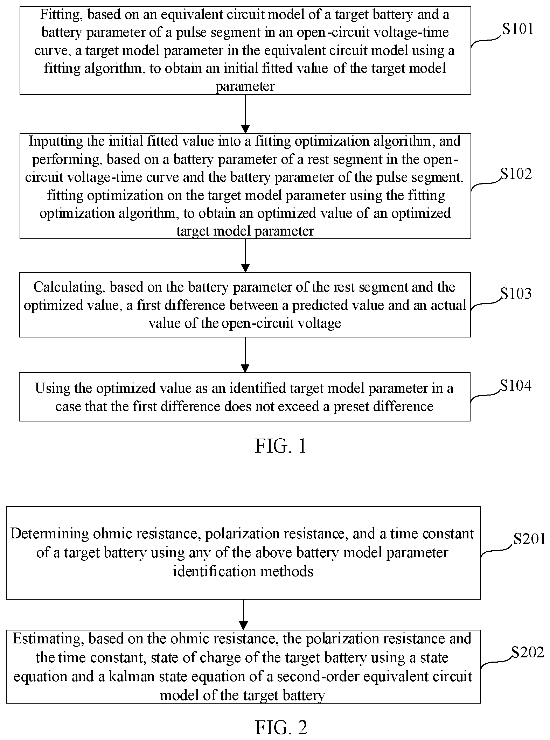

FIG. 1 is a flowchart of a battery model parameter identification method provided by an embodiment of the present invention. As shown in FIG. 1, the battery model parameter identification method provided by the embodiment of the present invention includes following steps:

Step S101, fitting, based on an equivalent circuit model of a target battery and a battery parameter of a pulse segment in an open-circuit voltage-time curve, a target model parameter in the equivalent circuit model using a fitting algorithm, to obtain an initial fitted value of the target model parameter, where the pulse segment is a time segment between adjacent parameter identification cycles in the open-circuit voltage-time curve, during which an open-circuit voltage decreases after an end of a previous parameter identification cycle and increases after a start of a next parameter identification cycle;

Step S102, inputting the initial fitted value into a fitting optimization algorithm, and performing, based on a battery parameter of a rest segment in the open-circuit voltage-time curve and the battery parameter of the pulse segment, fitting optimization on the target model parameter using the fitting optimization algorithm, to obtain an optimized value of an optimized target model parameter;

Step S103, calculating, based on the battery parameter of the rest segment and the optimized value, a first difference between a predicted value and an actual value of the open-circuit voltage; and

Step S104, using the optimized value as an identified target model parameter in a case that the first difference does not exceed a preset difference.

In the aforementioned battery model parameter identification method provided by the embodiments of the present invention, the fitting algorithm is firstly applied for fitting the target model parameter using the battery parameter of the pulse segment to obtain the initial fitted value of the target model parameter, and then the target model parameter is optimized based on the battery parameter of the rest segment using the fitting optimization algorithm to obtain the optimized value. Consequently, the target model parameter that satisfies voltage errors of both the pulse segment and the rest segment is obtained, thereby achieving technical effects of improving accuracy and precision in target model parameter identification and reducing an error in target model parameter identification.

The aforementioned target battery may be a lithium-ion battery, and the aforementioned equivalent circuit model may be a first-order RC (Resistor-Capacitor) equivalent circuit model, a second-order RC equivalent circuit model, a third-order RC equivalent circuit model, or a higher-order RC equivalent circuit model, and so on. In this embodiment, the second-order RC equivalent circuit model is adopted as the equivalent circuit model of the lithium-ion battery due to its relatively low computational load, relatively high precision, and ease of parameter identification.

In the second-order RC equivalent circuit model, there are a first-order RC circuit and a second-order RC circuit. The first-order RC circuit includes first-order polarization resistance R1 and first-order polarization capacitor C1, and the second-order RC circuit includes second-order polarization resistance R2 and second-order polarization capacitor C2. There is also ohmic resistance R0 in a main circuit path.

The aforementioned battery parameter is obtained through a test, such as a HPPC (Hybrid Pulse Power Characteristic) test, or an OCV test. The aforementioned pulse segment is the time segment between the adjacent parameter identification cycles in the open-circuit voltage-time curve, during which the open-circuit voltage decreases after the end of the previous parameter identification cycle and increases after the start of the next parameter identification cycle.

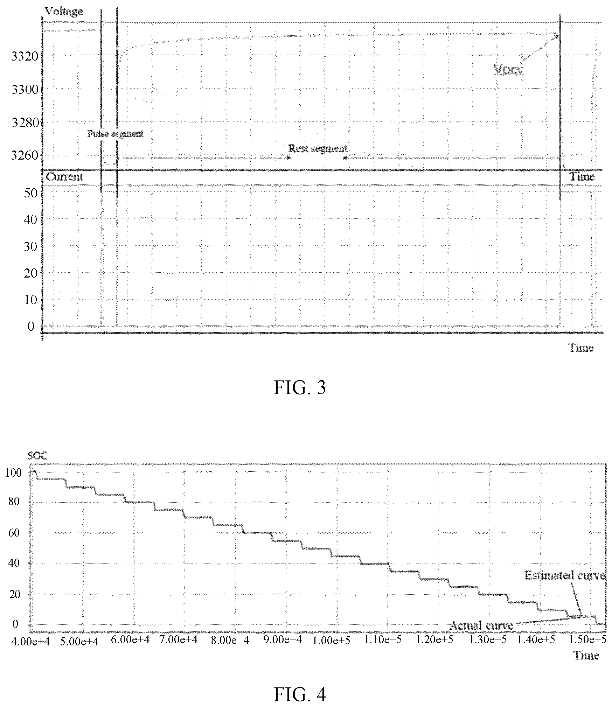

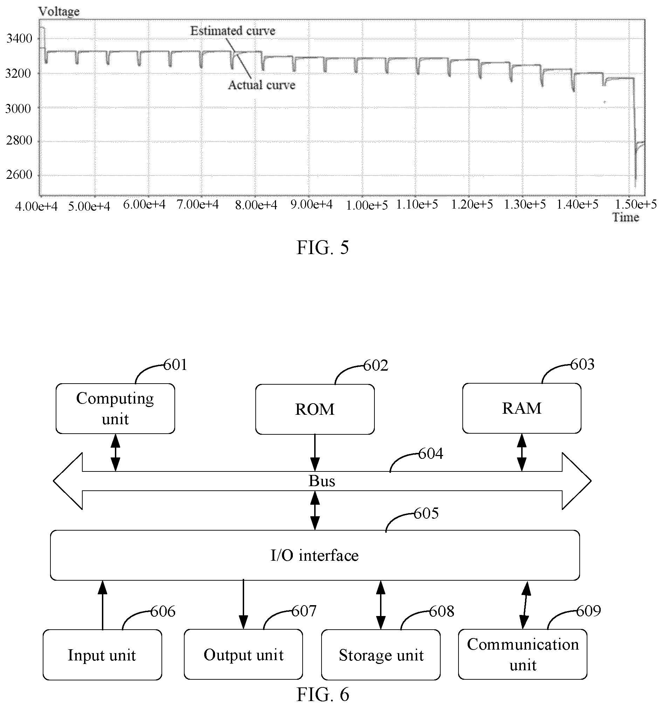

As shown in FIG. 5, the open-circuit voltage-time curve changes periodically with an adjustment cycle of state of charge. Specifically, as shown in FIG. 3, within one cycle, the open-circuit voltage during the pulse segment decreases from its nominal value to a minimum value, and then the rest segment (also known as a dwell segment, a constant current segment, and so on) enters, the open-circuit voltage during the rest segment rebounds from the minimum value back toward the nominal value and is subsequently maintained until a next pulse segment.

Since the pulse segment is a time segment during which current is injected in pulse form, fitting a parameter based on the pulse segment yields excellent current-response performance. Therefore, the target model parameter is fitted based on the battery parameter of the pulse segment. This means that the target model parameter in the equivalent circuit model is fitted using the fitting algorithm, based on the equivalent circuit model of the target battery and the battery parameter of the pulse segment, so as to obtain the initial fitted value of the target model parameter.

However, relying solely on the battery parameter of the pulse segment results in a relatively large prediction error for data of the rest segment. Therefore, in this embodiment, the initial fitted value is input into the fitting optimization algorithm, and then the fitting optimization is performed on the target model parameter using the fitting optimization algorithm, based on the battery parameter of the rest segment and the battery parameter of the pulse segment, so as to obtain the optimized value of the optimized target model parameter.

The aforementioned fitting optimization algorithm is essentially a fitting algorithm that jointly utilizes the battery parameter of the rest segment and the battery parameter of the pulse segment to fit the target model parameter (i.e., to optimize the initial fitted value of the target model parameter), thereby obtaining the optimized value after the fitting optimization. In this case, the optimized value not only has the current-response performance of the pulse segment but also has a relatively small prediction error for data of the rest segment.

However, the target model parameter is firstly fitted using the fitting algorithm, based on the battery parameter of the pulse segment, and then the fitting optimization is performed on the target model parameter using the fitting optimization algorithm, based on the battery parameter of the rest segment and the battery parameter of the pulse segment, which essentially involves two fitting. Consequently, this easily leads to an overfitting issue, thereby resulting in a decline in accuracy.

Accordingly, in this embodiment, a predicted value of the open-circuit voltage is calculated based on the battery parameter of the rest segment, an optimized value of polarization resistance and an optimized value of a time constant, and a first difference between the predicted value of the open-circuit voltage and an actual value of the open-circuit voltage characterizes a degree of overfitting. The larger the first difference, the more severe the overfitting; and the smaller the first difference, the less severe the overfitting. In a case that the first difference does not exceed a preset difference, the optimized value is used as the identified target model parameter, so as to ensure accuracy and precision in target model parameter identification, and reduce an error in target model parameter identification.

As an optional embodiment, the method further includes: calculating, based on the battery parameter of the pulse segment and the optimized value, a second difference between a predicted value and an actual value of a terminal voltage of the pulse segment in a case that the first difference exceeds the preset difference; scaling, based on the second difference, the optimized value, to obtain a correction value; using the correction value as a current optimized value, and recalculating, based on the battery parameter of the rest segment and the current optimized value, a first difference between a predicted value and an actual value of the open-circuit voltage; and using the current optimized value as an identified target model parameter in a case that the first difference after recalculation does not exceed the preset difference.

In the case that the first difference exceeds the preset difference, it indicates that the overfitting issue is relatively severe. The second difference between the predicted value and the actual value of the terminal voltage of the pulse segment is calculated, the optimized value is scaled based on the second difference to obtain the correction value, and a first difference between a predicted value and an actual value of the open-circuit voltage is recalculated based on the correction value until the first difference no longer exceeds the preset difference. Therefore, accuracy and precision in target model parameter identification are ensured, and an error in target model parameter identification is reduced.

In an example, polarization resistance $R_1$ and $R_2$ obtained from fitting are scaled as follows: $R_1 = R_{10} \pm R_{dev} * coe$, and $R_2 = R_{20} \pm R_{dev} * (1 - coe)$, where $coe = R_{10}/(R_{10} + R_{20})$, $R_{dev} = V_{dev}/I_{ave}$, the $V_{dev}$ is a voltage deviation between a fitted value and an actual value of the terminal voltage of the pulse segment, the $R_{dev}$ may be understood as a corresponding resistance deviation, and the $R_{10}$ and the $R_{20}$ are polarization resistance obtained before scaling. Finally, the open-circuit voltage of the rest segment is fitted using the polarization resistance $R_1$ and $R_2$ obtained after scaling, and magnitude of a corresponding first difference relative to the preset difference is observed.

As an optional embodiment, the calculating, based on the battery parameter of the rest segment and the optimized value, the first difference between the predicted value and the actual value of the open-circuit voltage of the rest segment includes: calculating, based on optimized values of polarization resistance and a time constant in the target model parameter and the battery parameter of the rest segment, the predicted value of the open-circuit voltage of the rest segment; and calculating the first difference based on the predicted value of the open-circuit voltage of the rest segment and the actual value, in the battery parameter of the rest segment, of the open-circuit voltage of the rest segment.

During a fitting optimization process, in order to satisfy precision requirements of both the pulse segment and the rest segment, an overfitting phenomenon may occur, causing a predicted voltage to deviate significantly from an actual voltage under a prolonged charge-discharge condition. Therefore, a voltage is fitted using an original battery parameter, based on the polarization resistance $R_1$ and $R_2$ obtained from fitting, and the time constants $\tau_1$ and $\tau_2$ obtained from fitting, and the predicted voltage is compared with the actual voltage in the original battery parameter, so as to evaluate the first difference.

For example, the original battery parameter may be an original voltage, in the battery parameter, of the target battery discharging from 100% SOC to 0% SOC. The polarization resistance $R_1$ and $R_2$ obtained from fitting, as well as the time constants $\tau_1$ and $\tau_2$ obtained from fitting are substituted back into an equation used during a fitting process, so as to back-calculate a corresponding voltage value, which may be used as the predicted voltage of the target battery. The above predicted voltage may be an open-circuit voltage or a terminal voltage of the target battery, or a planned voltage or an ohmic voltage of an equivalent circuit, and so on.

As an optional embodiment, the fitting, based on the equivalent circuit model of the target battery and the battery parameter of the pulse segment, the target model parameter in the equivalent circuit model using the fitting algorithm, to obtain the initial fitted value of the target model parameter includes: calculating, based on a terminal voltage of the pulse segment and an initial voltage of the rest segment, ohmic resistance; determining, based on the ohmic resistance and the battery parameter of the pulse segment, an initial value and upper and lower limits of polarization resistance; and using an initial value and upper and lower limits of a time constant that are preset, the initial value and the upper and lower limits of the polarization resistance, and a value of the ohmic resistance as the initial fitted value of the target model parameter, where the target model parameter includes ohmic resistance, polarization resistance, and a time constant.

The ohmic resistance is calculated based on the terminal voltage of the pulse segment and the initial voltage of the rest segment using the following formula: $R_0 = |\frac{U_d - U_c}{I_1}|$, that is, the ohmic resistance $R_0$ is calculated based on Ohm's law using the initial voltage $U_d$ of the rest segment and the terminal voltage $U_c$ of the pulse segment, and a terminal current $I_1$ of the pulse segment.

The initial value and the upper and lower limits of the polarization resistance are calculated based on the ohmic resistance and the battery parameter of the pulse segment using the following formula: $V_{p\_tot} = U_c - U_a - I * R_0 - dOCV$, and $R_{tot} = V_{p\_tot}/I_{ave}$, where the $U_c$ is the terminal voltage of the pulse segment, the $U_a$ is an initial voltage of the pulse segment, the $dOCV$ is an OCV difference between adjacent SOC, the $I_{ave}$ is an average current of the pulse segment, the $V_{p\_tot}$ is a total polarization voltage, and the $R_{tot}$ is a total polarization resistance. The initial value and the upper and lower limits of the time constant are preset.

The initial values and the upper and lower limits of the time constants $\tau_1$ and $\tau_2$ that are preset, the initial values and the upper and lower limits of the polarization resistance $R_1$ and $R_2$, and the value of the ohmic resistance $R_0$ are all used as the initial fitted value of the target model parameter.

As an optional embodiment, before the fitting, based on the equivalent circuit model of the target battery and the battery parameter of the pulse segment, the target model parameter in the equivalent circuit model using the fitting algorithm, to obtain the initial fitted value of the target model parameter, the method further includes: testing the target battery to obtain test data during a testing process, where the test data includes the battery parameter; and preprocessing the test data to obtain the open-circuit voltage-time curve and a battery parameter of each time segment, where the battery parameter of each time segment includes at least one of the following: a current, a voltage, capacity, time, a temperature, state of charge of a battery.

The above battery parameter is obtained through a test, such as a HPPC test, or an OCV test. After the test is completed, the test data obtained from the test is preprocessed, such as filtering, or denoising, to obtain battery parameters under different temperatures, different currents, and different SOC. The battery parameters mainly include a current, a voltage, capacity, test time, and a cell temperature during a testing process, and SOC calculated based on device capacity during a charging and discharging process, and so on.

As an optional embodiment, the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter includes: using an initial fitted value of a time constant as an initial value, and inputting the initial value into a fitting optimization function; calculating, based on the battery parameter of the pulse segment and the battery parameter of the rest segment, an open-circuit voltage of the target battery using the fitting optimization function; determining, based on the open-circuit voltage of the target battery and an actual open-circuit voltage of the target battery, a voltage error value; using a value of the time constant as an optimized value of the time constant in a case that the voltage error value is less than a preset maximum allowable error; and calculating, based on the optimized value of the time constant, an optimized value of polarization resistance.

The above fitting optimization function may be the lsqcurvefit function built into Matlab, the initial fitted values of the time constants $\tau_1$ and $\tau_2$ obtained from fitting are input into the lsqcurvefit function as the initial values, and the battery parameter of the pulse segment and the battery parameter of the rest segment are jointly input into the lsqcurvefit function as fitting data, so as to carry out the fitting optimization.

The preset maximum allowable error of the fitting optimization is set. After a corresponding target model parameter is obtained from each fitting, the open-circuit voltage is fitted based on the corresponding target model parameter. The voltage error value is determined based on the calculated open-circuit voltage and the actual open-circuit voltage. The value of the time constant is used as the optimized value of the time constant in the case that the voltage error value is less than the preset maximum allowable error, and the optimized value of the polarization resistance is calculated based on the optimized value of the time constant.

In a case that the voltage error value is not less than the preset maximum allowable error, the initial value of the time constant is adjusted within the upper and lower limits of the time constant, and the fitting optimization is continued until the voltage error value is less than the preset maximum allowable error, and then the values of the polarization resistance $R_1$ and $R_2$ obtained from fitting are output, so as to obtain a relatively accurate optimized value that can satisfy precision requirements of both the pulse segment and the rest segment. In this case, the values of the time constants $\tau_1$ and $\tau_2$, the values of the polarization resistance $R_1$ and $R_2$, and the value of the ohmic resistance $R_0$ are all used as the optimized value.

As an optional embodiment, the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter further includes: in a case that the voltage error value is not less than the preset maximum allowable error, performing statistical processing and filtering on the voltage error value, and determining a quantity of consecutive times for which the voltage error value is not less than the preset maximum allowable error; and in a case that the quantity of consecutive times reaches a quantity of preset times, adjusting, based on upper and lower limits of the time constant, the initial value of the time constant, and recalculating the open-circuit voltage and a voltage error value until the voltage error value is less than the preset maximum allowable error.

It should be noted that in the case that the voltage error value is not less than the preset maximum allowable error, a plurality of voltage error values obtained from the statistical processing are filtered. If the voltage error value is greater than the preset maximum allowable error for more than ten consecutive times, that is, the quantity of consecutive times may be 10, adjustment for the upper limits and the initial values of the time constants $\tau_1$ and $\tau_2$ are triggered. If the adjustment are triggered, the upper limits of the time constants $\tau_1$ and $\tau_2$ are automatically adjusted upward, respectively, and the initial values of the time constants $\tau_1$ and $\tau_2$ are adjusted upward, respectively.

Generally, when the time constant is adjusted, there is no need to adjust the lower limit, and only the upper limit and the initial value are adjusted upward.

The embodiments of the present invention also provide a battery state of charge estimation method. FIG. 2 is a flowchart of a battery state of charge estimation method provided by an embodiment of the present invention. As shown in FIG. 2, the battery state of charge estimation method provided by the embodiment of the present invention includes following steps:

Step S201, determining ohmic resistance, polarization resistance, and a time constant of a target battery using any of the above battery model parameter identification methods; and

Step S202, estimating, based on the ohmic resistance, the polarization resistance and the time constant, state of charge of the target battery using a state equation and a kalman state equation of a second-order equivalent circuit model of the target battery.

In the above battery state of charge estimation method provided by the embodiment of the present invention, the parameter identification is carried out using the above battery model parameter identification method. Therefore, the battery state of charge estimation method may have the technical effects of the above battery model parameter identification method, thereby causing the final battery SOC have relatively high accuracy.

In other embodiments, the above battery model parameter identification method may also be applied to estimation of an open-circuit voltage. The target model parameter is identified using any of the above battery model parameter identification methods, and the open-circuit voltage is estimated based on the identified target model parameter. The method for estimating a voltage is the same as that in related technologies.

It should be noted that this embodiment further provides an optional implementation, which will be described in detail below.

This implementation provides a parameter identification method, a first-order time constant $\tau_1$ and a second-order time constant $\tau_2$ are obtained using a least squares method, based on a second-order equivalent circuit model and a battery parameter of a pulse segment, and then the first-order time constant $\tau_1$ and the second-order time constant $\tau_2$ are optimized based on a battery parameter of a rest segment. A preset maximum allowable error of an open-circuit voltage is set. If a voltage error value between the open-circuit voltage obtained from fitting and an actual open-circuit voltage exceeds the preset maximum allowable error, initial values and upper limits of the first-order time constant $\tau_1$ and the second-order time constant $\tau_2$ are updated, and this process is iterated in a loop until the voltage error value satisfies the preset maximum allowable error, thereby obtaining the first-order time constant $\tau_1$ and the second-order time constant $\tau_2$ that may satisfy voltage errors of both the pulse segment and the rest segment, as well as first-order polarization resistance $R_1$ and second-order polarization resistance $R_2$. Finally, an EKF (Extended Kalman Filter) is employed for SOC estimation, so as to obtain SOC with relatively high precision.

The specific steps are as follows.

Firstly, under typical operating conditions of energy storage scenarios, HPPC and OCV (referring to a potential difference between two electrodes of a battery when the battery is not discharging and in an open-circuit state) tests are designed under different currents and different SOC at temperatures ranging from 0°C to 50°C.

Secondly, data obtained from the tests are preprocessed, such as filtering, or noise reduction, to obtain battery parameters under different temperatures, different currents, and different SOC. The battery parameters mainly include a current, a voltage, capacity, test time, and a cell temperature during a testing process, and SOC calculated based on device capacity during a charging and discharging process, and so on.

Thirdly, a lithium-ion battery model is created based on a second-order equivalent circuit, and based on a second-order equivalent circuit model, a terminal voltage of the lithium-ion battery may be expressed as the following formula:

$$U_t = U_{OCV} + U_1 + U_2 + U_r$$

where the $U_{OCV}$ is an open-circuit voltage of the second-order equivalent circuit model of the lithium-ion battery, the $U_1$ is a first-order polarization voltage of the second-order equivalent circuit model of the lithium-ion battery, the $U_2$ is a second-order polarization voltage of the second-order equivalent circuit model of the lithium-ion battery, and the $U_r$ is an ohmic voltage of the second-order equivalent circuit model of the lithium-ion battery. Based on Kirchhoft's current and voltage laws and Ohm's law, calculations of the first-order polarization voltage $U_1$, the second-order polarization voltage $U_2$ and the ohmic voltage $U_r$ may be expressed as the following formulas:

$$U_r = I * R_0;$$

$$C_1 \frac{dU_1}{dt} + \frac{U_1}{R_1} = I;$$

$$C_2 \frac{dU_2}{dt} + \frac{U_2}{R_2} = \mathrm{I}.$$

After first-order partial differentiation is performed on the calculation formulas of the first-order polarization voltage $U_1$ and the second-order polarization voltage $U_2$, the following results may be obtained:

$$U_1(t) = I * R_1 * \left(1 - e^{-\frac{dt}{\tau_1}}\right) + U_1(t-1) * e^{-\frac{dt}{tau1}};$$

$$U_2(t) = I * R_2 * \left(1 - e^{-\frac{dt}{\tau_2}}\right) + U_2(t-1) * e^{-\frac{dt}{\tau_2}}$$

where the dt is a time length, the I is a current, the $R_0$ is ohmic resistance of the lithium-ion battery, the $R_1$ and $R_2$ are polarization resistance of the lithium-ion battery, and the $\tau_1$ and $\tau_2$ are time constants of the lithium-ion battery, and calculation formulas of the time constants $\tau_1$ and $\tau_2$ are:

$$\tau_1 = C_1 * R_1;$$

$$\tau_2 = C_2 * R_2$$

where the $C_1$ is first-order polarization capacitance of the second-order equivalent circuit model of the lithium-ion battery, and the $C_2$ is second-order polarization capacitance of the second-order equivalent circuit model of the lithium-ion battery.

Fourthly, parameter fitting is carried out based on the second-order equivalent circuit model of the lithium-ion battery, and the steps are as follows.

First, a temperature, SOC, and a current are set for each fitting, and the preprocessed battery parameter is input into a fitting data script to carry out SOC matching. A terminal voltage $U_{OCV}$ and an initial voltage $U_d$ of the rest segment, and a terminal voltage $U_c$ of the pulse segment under different SOC are extracted, and the ohmic resistance $R_0$ is calculated based on Ohm's law:

$$R_0 = \left|\frac{U_d - U_c}{I_1}\right|$$

where the $I_1$ is a terminal current of the pulse segment.

Before the parameter fitting, an initial value and upper and lower limits of each parameter may be first defined. Specifically, total polarization resistance of the pulse segment is calculated as the following formulas:

$$V_{p\_tot} = U_c - U_a - I * R_0 - dOCV;$$

$$R_{tot} = V_{p\_tot}/I_{ave}$$

where the $U_c$ is the terminal voltage of the pulse segment, the $U_a$ is an initial voltage of the pulse segment, the $dOCV$ is an open-circuit voltage difference between adjacent SOC, the $I_{ave}$ is an average current of the pulse segment, the $V_{p\_tot}$ is a total polarization voltage, and the $R_{tot}$ is the total polarization resistance.

Then, initial fitted values of the time constants $\tau_1$ and $\tau_2$ obtained from fitting are input into the lsqcurvefit function built into Matlab as initial values, and the battery parameter of the pulse segment and the battery parameter of the rest segment are jointly input into the lsqcurvefit function built into Matlab as fitting data, so as to carry out fitting optimization. A preset maximum allowable error is set for the fitting optimization, and a plurality of voltage error values obtained from statistical processing are filtered. If the voltage error value is greater than the preset maximum allowable error for more than ten occurrences, adjustment for the upper limits and the initial values of the time constants $\tau_1$ and $\tau_2$ are triggered. If the adjustment are triggered, the upper limits of the time constants $\tau_1$ and $\tau_2$ are automatically adjusted upward, respectively, and the initial values of the time constants $\tau_1$ and $\tau_2$ are adjusted upward, respectively, until the voltage error value is less than the preset maximum allowable error. Then, values of the polarization resistance $R_1$ and $R_2$ obtained from fitting are output, so as to obtain a relatively accurate optimized value that can satisfy precision requirements of both the pulse segment and the rest segment. In this case, the values of the time constants $\tau_1$ and $\tau_2$, the values of the polarization resistance $R_1$ and $R_2$ and the value of the ohmic resistance $R_0$ are all used as the optimized value.

Finally, during a fitting optimization process, in order to satisfy precision requirements of both the pulse segment and the rest segment, an overfitting phenomenon may occur, causing a predicted voltage to deviate significantly from an actual voltage under a prolonged charge-discharge condition. Therefore, based on the polarization resistance $R_1$ and $R_2$ obtained from fitting, and the time constants $\tau_1$ and $\tau_2$ obtained from fitting, and using original voltage data from 100% SOC discharge to 0% SOC, it is determined whether the polarization resistance $R_1$ and $R_2$ obtained from fitting, and the time constants $\tau_1$ and $\tau_2$ obtained from fitting are consistent with an actual situation of the original voltage data. Specifically, the polarization resistance $R_1$ and $R_2$ obtained from fitting, and the time constants $\tau_1$ and $\tau_2$ obtained from fitting may be input into the original voltage data, a fitted voltage corresponding to the polarization resistance $R_1$ and $R_2$ obtained from fitting, and the time constants $\tau_1$ and $\tau_2$ obtained from fitting is calculated, and it is determined whether a first difference between the fitted voltage and an actual voltage exceeds a preset difference. If a situation where the first difference exceeds the preset difference occurs, the polarization resistance $R_1$ and $R_2$ obtained from fitting are scaled using a voltage error value (i.e., a second difference) of the terminal voltage of the pulse segment as follows:

$$R_1 = R_{10} \pm R_{dev} * coe;$$

$$R_2 = R_{20} \pm R_{dev} * (1 - \text{coe})$$

where coe = $R_{10}/(R_{10} + R_{20})$, $R_{dev} = V_{dev}/I_{ave}$, the $V_{dev}$ is a voltage deviation (i.e., the second difference) between a fitted value and an actual value of the terminal voltage of the pulse segment, the $R_{dev}$ may be understood as a corresponding resistance deviation, and the $R_{10}$ and the $R_{20}$ are the polarization resistance obtained from fitting in the previous steps.

Finally, an open-circuit voltage of the rest segment is fitted using the polarization resistance $R_1$ and $R_2$ after scaling, and magnitude of a corresponding first difference relative to the preset difference is observed.

Fifthly, SOC is estimated using an EKF algorithm, based on the ohmic resistance $R_0$ obtained from fitting, the polarization resistance $R_1$ and $R_2$ obtained from fitting, and the time constants $\tau_1$ and $\tau_2$ obtained from fitting in the previous steps. The specific procedures are as follows.

1) A Kalman filter state equation may be expressed as follows:

$$X_k = AX_{k-1} + BU_{k-1}$$

where the $X_k$ refers to a state vector, the $U_k$ refers to a state control vector, which may refer to a current in a battery, the A is a state transition matrix, and the B is a control variable matrix. Based on this, a prior state value estimation may be expressed as follows:

$$x_k = Ax_{k-1} + Bu_{k-1}.$$

A prior state covariance $P_k$ may be expressed as follows:

$$P_k = AP_{k-1}A^T + Q$$

where the Q is a system noise covariance matrix.

A Kalman gain $K_k$ may be expressed as follows:

$$K_k = \frac{P_k H^T}{HP_k H^T + R}$$

where the H is a transformation matrix from the state vector to a measuring vector, and the R is a covariance matrix for measuring noise.

A posterior state value estimation is as follows:

$$x_k = x_k + K_k (Z_k - Hx_k)$$

where the $Z_k$ is the measuring vector.

A posterior covariance is as follows:

$$P_k = (I - K_k H) * P_k.$$

2) Based on the second-order equivalent circuit model, a state equation of the lithium-ion battery may be expressed as:

$$\begin{bmatrix} U_1(t) \\ U_2(t) \\ SOC(t) \end{bmatrix} = \begin{bmatrix} 1-\frac{dt}{\tau_1} & 0 & 0 \\ 0 & 1-\frac{dt}{\tau_2} & 0 \\ 0 & 0 & 1 \end{bmatrix} * \begin{bmatrix} U_1(t-1) \\ U_1(t-1) \\ SOC(t-1) \end{bmatrix} + \begin{bmatrix} \frac{dt}{C_1} \\ \frac{dt}{C_2} \\ \frac{-dt}{cap} \end{bmatrix} * I;$$

$$U_t = OCV + \begin{bmatrix} -1 \\ -1 \\ 0 \end{bmatrix} * \begin{bmatrix} U_1(t) \\ U_2(t) \\ SOC \end{bmatrix} - I * R_0$$

where the $U_t$ represents a predicted terminal voltage of a cell;

3) By combining a kalman state equation, the following may be derived:

$$X_k = \begin{bmatrix} U_1(t) \\ U_2(t) \\ SOC(t) \end{bmatrix};$$

$$A = \begin{bmatrix} 1-\frac{dt}{R_1 C_1} & 0 & 0 \\ 0 & 1-\frac{dt}{R_2 C_2} & 0 \\ 0 & 0 & 1 \end{bmatrix};$$

$$B = \begin{bmatrix} \frac{dt}{C_1} \\ \frac{dt}{C_2} \\ \frac{-dt}{cap} \end{bmatrix}.$$

4) An initial system covariance, a measuring covariance, and a state error covariance of a Kalman filter are set, SOC and a voltage are estimated using a target model parameter obtained from fitting, and parameter precision is determined.

This implementation further provides a SOC estimation result and a voltage estimation result of test data. FIG. 4 is a schematic diagram of an estimated curve and an actual curve of battery state of charge versus time provided by an implementation of the present invention. As shown in FIG. 4, parameter identification is carried out according to this implementation, and SOC estimation is carried out based on an identified target model parameter. The estimated SOC closely matches actual SOC, indicating relatively high accuracy. FIG. 5 is a schematic diagram of an estimated curve and an actual curve of an open-circuit voltage versus time provided by an implementation of the present invention. As shown in FIG. 5, parameter identification is carried out according to this implementation, and voltage estimation is carried out based on an identified target model parameter. The estimated voltage closely matches an actual voltage, indicating relatively high accuracy.

In this implementation, the battery parameter of the pulse segment during a HPPC test process is used as fitting data for the time constants $\tau_1$ and $\tau_2$, and then the battery parameter of the pulse segment and the battery parameter of the rest segment are jointly used as fitting data for the polarization resistance $R_1$ and $R_2$. During a parameter fitting process, and after filtering, it is determined whether the initial values and the upper and lower limits of the time constants $\tau_1$ and $\tau_2$ are appropriate, based on a preset maximum allowable error. If the voltage error value is greater than the preset maximum allowable error, the upper and lower limits and the initial values of the time constants $\tau_1$ and $\tau_2$ are reset, so as to find optimal time constants $\tau_1$ and $\tau_2$, and optimal polarization resistance $R_1$ and $R_2$. By combining an EKF and other SOC estimation methods, the target model parameter obtained from fitting matches a fitting error, so as to obtain an estimated SOC value. A method in this implementation may be used for parameter fitting based on a first-order equivalent circuit model, a second-order equivalent circuit model, a third-order equivalent circuit model, and a higher-order equivalent circuit model.

When this implementation is implemented, the time constants $\tau_1$ and $\tau_2$ of the pulse segment and the rest segment, and the polarization resistance $R_1$ and $R_2$ of the pulse segment and the rest segment may also be fitted separately, so as to obtain two different sets of target model parameters, and then an appropriate switching algorithm is employed, thereby better satisfying precision requirements of both the rest segment and the pulse segment. When the parameter identification method in this implementation is adopted, the target model parameter of the second-order equivalent circuit model with relatively high precision is obtained, and under a condition of an EKF algorithm, estimation precision of both the SOC and the voltage are greatly improved.

Based on the above battery model parameter identification method provided by the embodiments of the present invention, the embodiments of the present invention further provide a battery model parameter identification apparatus, which includes:

a fitting module, configured to fit, based on an equivalent circuit model of a target battery and a battery parameter of a pulse segment in an open-circuit voltage-time curve, a target model parameter in the equivalent circuit model using a fitting algorithm, to obtain an initial fitted value of the target model parameter, where the pulse segment is a time segment between adjacent parameter identification cycles in the open-circuit voltage-time curve, during which an open-circuit voltage decreases after an end of a previous parameter identification cycle and increases after a start of a next parameter identification cycle;

an optimization module, configured to input the initial fitted value into a fitting optimization algorithm, and perform, based on a battery parameter of a rest segment in the open-circuit voltage-time curve and the battery parameter of the pulse segment, fitting optimization on the target model parameter using the fitting optimization algorithm, to obtain an optimized value of an optimized target model parameter;

a detection module, configured to calculate, based on the battery parameter of the rest segment and the optimized value, a first difference between a predicted value and an actual value of the open-circuit voltage; and

an identification module, configured to use the optimized value as an identified target model parameter in a case that the first difference does not exceed a preset difference.

In the aforementioned battery model parameter identification apparatus provided by the embodiments of the present invention, the fitting algorithm is firstly applied for fitting the target model parameter using the battery parameter of the pulse segment to obtain the initial fitted value of the target model parameter, and then the target model parameter is optimized based on the battery parameter of the rest segment using the fitting optimization algorithm to obtain the optimized value. Consequently, the target model parameter that satisfies voltage errors of both the pulse segment and the rest segment is obtained, thereby achieving technical effects of improving accuracy and precision in target model parameter identification and reducing an error in target model parameter identification.

The apparatus may also include other modules or units, or the aforementioned modules may also execute additional instructions. For specific implementation, reference may be made to the previously described method embodiments. The beneficial effects that may be achieved are also detailed in the method embodiments mentioned earlier, and thus will not be reiterated here.

Based on the above battery state of charge estimation method provided by the embodiments of the present invention, the embodiments of the present invention further provide a battery state of charge estimation apparatus, which includes:

a battery model parameter identification module, configured to determine ohmic resistance, polarization resistance, and a time constant of a target battery using any of the aforementioned battery model parameter identification methods; and

an estimation module, configured to estimate, based on the ohmic resistance, the polarization resistance and the time constant, state of charge of the target battery using a state equation and a kalman state equation of a second-order equivalent circuit model of the target battery.

The above battery state of charge estimation apparatus provided by the embodiments of the present invention, by virtue of the parameter identification performed by the aforementioned battery model parameter identification apparatus, may possess the technical effects of the battery model parameter identification apparatus, thereby enabling the final SOC to achieve relatively high accuracy.

The embodiments of the present invention further provide a non-transitory machine-readable medium storing a computer program, where the computer program is configured to cause a computer to execute the method of the embodiments of the present invention when executed by a processor of the computer.

The embodiments of the present invention further provide a computer program product, including a computer program, where the computer program is configured to cause a computer to execute the method of the embodiments of the present invention when executed by a processor of the computer.

The embodiments of the present invention further provide an energy storage device, i.e., an electronic device applied to an energy storage system, including: at least one processor; and a memory communicatively connected to the at least one processor. The memory stores a computer program that can be executed by the at least one processor, and the computer program is configured to cause the energy storage device to execute the method of the embodiments of the present invention when executed by the at least one processor.

With reference to FIG. 6, a structural block diagram of an energy storage device of a server or a client in the embodiments of the present invention is described, which is an example of a hardware device that may be applied to various aspects of the present invention. The energy storage device is intended to represent various forms of digital electronic computing devices, such as laptop computers, desktop computers, workstations, personal digital assistants, servers, blade servers, mainframe computers, and other suitable computers. The energy storage device may also represent various forms of mobile apparatuses, such as personal digital assistants, cellular phones, smartphones, wearable devices, and other similar computing apparatuses. Components illustrated herein, their connections and relationships, and their functions, are presented merely as examples and are not intended to limit the implementation of the present invention described and/or claimed herein.

As shown in FIG. 6, the energy storage device includes a computing unit 601, which may execute various appropriate actions and processes according to a computer program stored in a ROM (Read-Only Memory) 602 or a computer program loaded from a storage unit 608 into a RAM (Random-Access Memory) 603. Various programs and data required for the operation of the energy storage device may also be stored in the RAM 603. The computing unit 601, the ROM 602, and the RAM 603 are connected to each other via a bus 604, and an I/O (Input/Output) interface 605 is also connected to the bus 604.

A plurality of components in the energy storage device are connected to the I/O interface 605, including: an input unit 606, an output unit 607, a storage unit 608, and a communication unit 609. The input unit 606 may be any type of device capable of inputting information to the energy storage device, and may receive input digital or character information, as well as generate key signal inputs related to user settings and/or function control of the energy storage device. The output unit 607 may be any type of device capable of presenting information, and may include but is not limited to a display, a speaker, a video/audio output terminal, a vibrator, and/or a printer. The storage unit 608 may include but is not limited to a magnetic disk, or an optical disk. The communication unit 609 allows the energy storage device to exchange information/data with other devices through a computer network such as the Internet and/or various telecommunication networks, and may include but is not limited to a modem, a network card, an infrared communication device, and/or a wireless communication transceiver, such as a Bluetooth device, a WIFI device, a WiMAX device, a cellular communication device, and/or similar items.

The computing unit 601 may be various general-purpose and/or special-purpose processing components with processing and computing capabilities. Some examples of the computing unit 601 include but are not limited to a CPU, a GPU (Graphics Processing Unit), various dedicated AI (Artificial Intelligence) computing units, various computing units running machine learning model algorithms, a DSP (Digital Signal Processor), and any appropriate processors, controllers, microcontrollers, etc. The computing unit 601 executes various methods and processes described above. For example, in some embodiments, the method embodiments of the present invention may be implemented as a computer program, which is tangibly contained in a machine-readable medium, such as the storage unit 608. In some embodiments, part or all of the computer program may be loaded and/or installed onto the energy storage device via the ROM 602 and/or the communication unit 609. In some embodiments, the computing unit 601 may be configured to execute the above methods by any other appropriate means (for example, by means of firmware).

The computer program for implementing the method embodiments of the present invention may be written in any combination of one or more programming languages. These computer programs may be provided to a processor or a controller of a general-purpose computer, a special-purpose computer, or other programmable data processing apparatus, such that the functions/operations specified in the flowcharts and/or block diagrams are implemented when the computer program is executed by the processor or the controller. The computer program may be executed entirely on a machine or partially on a machine, or as an independent software package partially on a machine and partially on a remote machine, or entirely on a remote machine or server.

In the context of the embodiments of the present invention, the machine-readable medium may be a tangible medium that may include or store a program for use by, or in connection with, an instruction execution system, apparatus, or device. The machine-readable medium may be a machine-readable signal medium or a machine-readable storage medium. The machine-readable storage medium may include, but is not limited to, electronic, magnetic, optical, electromagnetic, or infrared systems, devices, or apparatuses, or any suitable combination thereof. More specific examples of the machine-readable storage medium may include electrical connections based on one or more wires, portable computer disks, hard disks, RAM (Random Access Memory), ROM (Read-Only Memory), EPROM (Erasable Programmable Read-Only Memory or flash memory), optical fibers, portable CD-ROM (Compact Disk Read-Only Memory), optical storage devices, magnetic storage devices, or any suitable combination thereof.

It should be noted that the term "including" and its variations used in the embodiments of the present invention are open-ended, meaning "including but not limited to". The term "based on" means "at least partially based on". The term "an embodiment" means "at least one embodiment"; the term "another embodiment" means "at least one additional embodiment"; and the term "some embodiments" means "at least some embodiments". The modifiers "a" and "a plurality of" mentioned in the embodiments of the present invention are illustrative rather than restrictive. Those skilled in the art should understand that unless explicitly stated otherwise in the context, they should be understood as "one or more".

User information (including but not limited to user device information, user personal information, and so on.) and data (including but not limited to data for analysis, stored data, displayed data, and so on.) involved in the embodiments of the present invention are all information and data that have been authorized by the user or fully authorized by all relevant parties. Moreover, collection, use, and processing of related data need to comply with relevant laws, regulations, and standards of relevant countries and regions, and corresponding operation interfaces are provided to allow users to choose whether to grant or refuse authorization.

Various steps described in the method implementations provided by the embodiments of the present invention may be executed in different orders and/or in parallel. In addition, the method implementations may include additional steps and/or omit execution of illustrated steps. The scope of protection of the present invention is not limited in this regard.

The term "embodiment" in this specification refers to the specific features, structures, or characteristics described in conjunction with the embodiments that may be included in at least one embodiment of the present invention. The appearance of this phrase at various places in the specification does not necessarily mean that it refers to the same embodiment, nor does it imply that it is mutually exclusive with other embodiments, possessing independence or being an alternative option. Each embodiment in this specification is described in a related manner, with identical or similar parts among different embodiments referring to each other. **In** particular, as for device, apparatus, and system embodiments, since they are basically similar to the method embodiments, they are described relatively concisely, with detailed explanations referring to the corresponding parts of the method embodiments.

The embodiments described above only express several implementations of the present invention, with relatively specific and detailed descriptions. However, this should not be understood as a limitation on the scope of protection. It should be pointed out that for those of ordinary skill in the art, without departing from the concept of the present invention, several modifications and improvements may still be made, and these all fall within the scope of protection of the present invention. Therefore, the scope of protection of the present invention should be subject to appended claims.

**Claims**

1. A battery model parameter identification method, comprising:

   fitting, based on an equivalent circuit model of a target battery and a battery parameter of a pulse segment in an open-circuit voltage-time curve, a target model parameter in the equivalent circuit model using a fitting algorithm, to obtain an initial fitted value of the target model parameter, wherein the pulse segment is a time segment between adjacent parameter identification cycles in the open-circuit voltage-time curve, during which an open-circuit voltage decreases after an end of a previous parameter identification cycle and increases after a start of a next parameter identification cycle;
   inputting the initial fitted value into a fitting optimization algorithm, and performing, based on a battery parameter of a rest segment in the open-circuit voltage-time curve and the battery parameter of the pulse segment, fitting optimization on the target model parameter using the fitting optimization algorithm, to obtain an optimized value of an optimized target model parameter;
   calculating, based on the battery parameter of the rest segment and the optimized value, a first difference between a predicted value and an actual value of the open-circuit voltage; and
   using the optimized value as an identified target model parameter in a case that the first difference does not exceed a preset difference.

2. The method according to claim 1, further comprising:

   calculating, based on the battery parameter of the pulse segment and the optimized value, a second difference between a predicted value and an actual value of a terminal voltage of the pulse segment in a case that the first difference exceeds the preset difference;
   scaling, based on the second difference, the optimized value, to obtain a correction value;
   using the correction value as a current optimized value, and recalculating, based on the battery parameter of the rest segment and the current optimized value, a first difference between a predicted value and an actual value of the open-circuit voltage; and

using the current optimized value as an identified target model parameter in a case that the first difference after recalculation does not exceed the preset difference.

3. The method according to claim 1 or 2, wherein the calculating, based on the battery parameter of the rest segment and the optimized value, the first difference between the predicted value and the actual value of the open-circuit voltage comprises:

   calculating, based on optimized values of polarization resistance and a time constant in the target model parameter and the battery parameter of the rest segment, the predicted value of the open-circuit voltage; and calculating the first difference based on the predicted value of the open-circuit voltage and the actual value, in the battery parameter of the rest segment, of the open-circuit voltage.

4. The method according to any one of claims 1 to 3, wherein the fitting, based on the equivalent circuit model of the target battery and the battery parameter of the pulse segment in the open-circuit voltage-time curve, the target model parameter in the equivalent circuit model using the fitting algorithm, to obtain the initial fitted value of the target model parameter comprises:

   calculating, based on a terminal voltage of the pulse segment and an initial voltage of the rest segment, ohmic resistance;
   determining, based on the ohmic resistance and the battery parameter of the pulse segment, an initial value and upper and lower limits of polarization resistance; and
   using an initial value and upper and lower limits of a time constant that are preset, the initial value and the upper and lower limits of the polarization resistance, and a value of the ohmic resistance as the initial fitted value of the target model parameter, wherein the target model parameter comprises ohmic resistance, polarization resistance, and a time constant.

5. The method according to claim 4, further comprising:

   testing the target battery to obtain test data during a testing process; and
   preprocessing the test data to obtain the open-circuit voltage-time curve and a battery parameter of each time segment, wherein the battery parameter of each time segment comprises at least one of the following: a current, a voltage, capacity, time, a temperature, state of charge of a battery.

6. The method according to any one of claims 1 to 5, wherein the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter comprises:

   using an initial fitted value of a time constant as an initial value, and inputting the initial value into a fitting optimization function;
   calculating, based on the battery parameter of the pulse segment and the battery parameter of the rest segment, the open-circuit voltage of the target battery using the fitting optimization function;
   determining, based on the open-circuit voltage of the target battery and an actual open-circuit voltage of the target battery, a voltage error value;
   using a value of the time constant as an optimized value of the time constant in a case that the voltage error value is less than a preset maximum allowable error; and
   calculating, based on the optimized value of the time constant, an optimized value of polarization resistance.

7. The method according to claim 6, wherein the inputting the initial fitted value into the fitting optimization algorithm, and the performing, based on the battery parameter of the rest segment in the open-circuit voltage-time curve and the battery parameter of the pulse segment, the fitting optimization on the target model parameter using the fitting optimization algorithm, to obtain the optimized value of the optimized target model parameter further comprises:

   in a case that the voltage error value is not less than the preset maximum allowable error, performing statistical processing and filtering on the voltage error value, and determining a quantity of consecutive times for which the voltage error value is not less than the preset maximum allowable error; and
   in a case that the quantity of consecutive times reaches a quantity of preset times, adjusting an initial value and an upper limit of a time constant, and recalculating the open-circuit voltage of the target battery and a voltage error value until the voltage error value is less than the preset maximum allowable error.

8. The method according to any one of claims 1 to 7, wherein the equivalent circuit model is a second-order resistor-capacitor equivalent circuit model.

9. A battery state of charge estimation method, comprising:

determining ohmic resistance, polarization resistance, and a time constant of a target battery using the battery model parameter identification method according to any one of claims 1 to 8; and
estimating, based on the ohmic resistance, the polarization resistance and the time constant, state of charge of the target battery using a state equation and a kalman state equation of a second-order equivalent circuit model of the target battery.

10. A battery open-circuit voltage estimation method, comprising:

determining an identified target model parameter using the battery model parameter identification method according to any one of claims 1 to 8; and
estimating, based on the identified target model parameter, an open-circuit voltage.

11. An energy storage device, comprising: a processor, and a memory storing a program, wherein the program comprises an instruction that, when executed by the processor, cause the processor to execute the method according to any one of claims 1 to 10.

12. A non-transitory machine-readable medium storing a computer instruction, wherein the computer instruction is configured to cause a computer to execute the method according to any one of claims 1 to 10.

13. A computer program product, comprising a computer program/instruction, wherein the computer program/instruction, when executed by a processor, implements the method according to any one of claims 1 to 10.

Fitting, based on an equivalent circuit model of a target battery and a battery parameter of a pulse segment in an open-circuit voltage-time curve, a target model parameter in the equivalent circuit model using a fitting algorithm, to obtain an initial fitted value of the target model parameter ⟋S101

Inputting the initial fitted value into a fitting optimization algorithm, and performing, based on a battery parameter of a rest segment in the open-circuit voltage-time curve and the battery parameter of the pulse segment, fitting optimization on the target model parameter using the fitting optimization algorithm, to obtain an optimized value of an optimized target model parameter ⟋S102

Calculating, based on the battery parameter of the rest segment and the optimized value, a first difference between a predicted value and an actual value of the open-circuit voltage ⟋S103

Using the optimized value as an identified target model parameter in a case that the first difference does not exceed a preset difference ⟋S104

FIG. 1

Determining ohmic resistance, polarization resistance, and a time constant of a target battery using any of the above battery model parameter identification methods ⟋S201

Estimating, based on the ohmic resistance, the polarization resistance and the time constant, state of charge of the target battery using a state equation and a kalman state equation of a second-order equivalent circuit model of the target battery ⟋S202

FIG. 2

FIG. 3

FIG. 4

FIG. 5

FIG. 6

## EUROPEAN SEARCH REPORT

Application Number

EP 25 19 4708

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 114 720 881 A (UNIV CHANGSHA SCIENCE & TECH) 8 July 2022 (2022-07-08) * the whole document * ----- | 1-13 | INV.<br>G01R31/367<br>G01R31/382 |
| A | CN 117 949 829 A (CHONGQING BIAONENG RUIYUAN ENERGY STORAGE TECH RESEARCH INSTITUTE CO L) 30 April 2024 (2024-04-30) * paragraph [0041] - paragraph [0085] * ----- | 1-13 | |

TECHNICAL FIELDS
SEARCHED      (IPC)

G01R

The present search report has been drawn up for all claims

| Place of search | Date of completion of the search | Examiner |
|---|---|---|
| Munich | 3 December 2025 | Mazagão Guerreiro, R |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 19 4708

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2025

| Patent document cited in search report | | Publication date | Patent family member(s) | Publication date |
|---|---|---|---|---|
| CN 114720881 | A | 08-07-2022 | NONE | |
| CN 117949829 | A | 30-04-2024 | NONE | |

EPO FORM P0459

For more details about this annex : see Official Journal of the European Patent Office, No. 12/82